# EUROPÄISCHE PATENTANMELDUNG

(11) **EP 1 231 650 A2**
(43) Veröffentlichungstag der Anmeldung: **14.08.2002**
(21) Anmeldenummer: 01130736.0
(22) Anmeldetag: 21.12.2001
(51) Int. Cl.: H01L 33/00

(54) **Reflektorbehaftetes Halbleiterbauelement**

(30) Priorität: 07.02.2001 DE 10105802
(71) Anmelder: Patent-Treuhand-Gesellschaft für elektrische Glühlampen mbH, 81543 München (DE)
(72) Erfinder: Schliep, Karl-Peter, 81737 München (DE); Wagner, Norbert, 80469 München (DE)

(57) **Zusammenfassung**

Ein reflektorbehaftetes Halbleiterbauelement (21), das eine strahlungsemittierende LED (22) umfasst, sitzt in einem Gehäuse, das zumindest ein Basisteil (30) und einen Reflektor (23) für die Strahlung der LED umfasst, wobei die LED (22) im Scheitel des Reflektors an einem Podest (25) befestigt ist.

## Beschreibung

### Technisches Gebiet

Die Erfindung betrifft ein Reflektorbehaftetes Halbleiterbauelement gemäß dem Oberbegriff des Anspruchs 1. Es handelt sich dabei insbesondere um einen LED-Chip, der in einem Reflektor sitzt.

### Stand der Technik

Aus der WO 97/50132 ist ein Reflektorbehaftetes Halbleiterbauelement bekannt. Die LED ist direkt auf dem Boden des Reflektors befestigt. Die Reflektorkontur ist kegelstumpfartig. Aus der US-A 5 813 753 ist ein weiteres Reflektorbehaftetes Halbleiterbauelement bekannt. Der Scheitelbereich, in dem der Chip sitzt, ist eben. Die Kontur hat einen gebogenen Bereich, der hauptsächlich die Strahlung reflektiert.

Aus der DE-A 100 06 738 (noch nicht offengelegt) und der DE-A 198 07 758 ist ein Halbleiterbauelement bekannt, bei dem die Seitenflächen des Chips schräg zu seiner Decken- und Bodenfläche stehen. Damit wird die Lichtauskopplung zwar verbessert, jedoch ohne dass dies in einem Reflektor besonders nutzbar wäre.

### Darstellung der Erfindung

Es ist Aufgabe der vorliegenden Erfindung, ein reflektorbehaftetes Halbleiterbauelement gemäß dem Oberbegriff des Anspruchs 1 bereitzustellen, das die nach vorne gerichtete Lichtauskopplung verbessert.

Diese Aufgabe wird durch die kennzeichnenden Merkmale des Anspruchs 1 gelöst. Besonders vorteilhafte Ausgestaltungen finden sich in den abhängigen Ansprüchen.

Im einzelnen handelt es sich erfindungsgemäß um ein Reflektorbehaftetes Halbleiterbauelement, das eine strahlungsemittierende LED umfasst, die in einem Gehäuse sitzt, wobei das Gehäuse zumindest ein Basisteil und einen Reflektor für die Strahlung der LED umfasst, wobei die LED mit dem Scheitel des Reflektors, evtl. realisiert durch eine gerade Bodenplatte, über ein Podest verbunden ist, also im Scheitel erhöht sitzt. Die LED emittiert insbesondere im sichtbaren Strahlungsbereich, aber auch im UV oder IR, und kann beispielsweise durch eine InGaN-LED realisiert sein. Der Reflektor kann integraler Bestandteil des Basisteils sein oder beispielsweise ein darauf aufgesetztes oder zentral in ihm enthaltenes Bauteil. Die LED sitzt zentral im Reflektorscheitel in der Achse des Reflektors. Die Kontur des Reflektors kann unterschiedlichen Zwecken angepasst sein, insbesondere kann der Scheitel von einem separaten Scheitelbauteil gebildet werden. Dies kann beispielsweise eine Bodenplatte oder die Abdeckung des Basisteils sein. Mit diesem Konzept ist es möglich, auch eine nicht nach vorn gerichtete Lichtabstrahlung der LED effektiv im Reflektor zu sammeln und somit den Gesamtlichtstrom zu erhöhen.

Insgesamt kann die erfindungsgemäße Anordnung den nicht nutzbaren Raumwinkelanteil im Reflektor verkleinern. Damit wird die Abschattung (Vignettierung) verringert, die normalerweise erheblich stört, da bisher Chip und Reflektor nicht aufeinander abgestimmt werden konnten. Die Chips waren mit Abmessungen von mehreren Hundert µm relativ groß für den Reflektor, der typischerweise einen Durchmesser an seiner Öffnung von etwa 1 bis 2 mm hatte. Häufig ist Durchmesser und Tiefe des Reflektors durch äußere Zwänge bestimmt, während andererseits die Abmessungen des Chips vom Hersteller nicht beliebig variiert werden können. Aufgrund des mit dem Podest gewonnen Freiheitsgrades kann jetzt als Reflektor beispielsweise eine Parabel mit optimaler Brennweite, also länger als vorher, verwendet werden. Auch bei relativ großer Reflektoröffnung wird immer noch eine gleichmäßige Abstrahlung erreicht.

Vorteilhaft ist das neuartige Konzept auch bei Anwendung auf ein Array von LEDs. Hier kann bei gleicher Bauhöhe eine vorgegebene Fläche für ein Array wesentlich wirkungsvoller mit Halbleiterbauelementen bestückt werden, da der Abstand zwischen den einzelnen Halbleiterbauelementen vergrößert werden kann, weil die Reflektoröffnung vergrößert werden kann. Insbesondere kann das Array gleichmäßiger ausgeleuchtet werden.

Oft besitzt die LED jeweils eine rechteckige Bodenfläche und Deckenfläche, wobei die Deckenfläche der LED zur Öffnung des Reflektors zeigt.

Besonders bevorzugt ist eine LED, die sich nach unten, zum Scheitel hin, verjüngt. Insbesondere ist die gesamte Fläche der Bodenfläche kleiner als die der Deckenfläche. Dabei wird ein erheblicher Teil der von der LED emittierten Strahlung seitlich oder nach unten abgestrahlt und würde entweder ungerichtet als Streulicht aus dem Reflektor entweichen oder im Bereich des Scheitels, evtl. von der LED, absorbiert. Durch Verwendung des Podests ist es möglich, mehr Licht wirksam zu nutzen und das System Reflektor-LED optimal aufeinander abzustimmen, so dass der wirksame Lichtstrom erheblich gesteigert werden kann, insbesondere um etwa 10 bis 80 %, je nach konkreter Ausgestaltung. Insbesondere ist zu bedenken, dass die LED in jedem Fall im Scheitel befestigt werden muss, üblicherweise mittels eines Klebers. Die erhöhte Position der LED verhindert jetzt ein Abfließen des Klebers in die wirksame Reflektorfläche. Außerdem wird von der LED selbst weniger Licht, das von der Reflektorkontur zurückgestrahlt wird, absorbiert. Durch den zusätzlichen Freiheitsgrad der erfindungsgemäßen Anordnung wird es möglich, die gewünschte Abstrahlcharakteristik genau zu optimieren. beispielsweise kann die LED jetzt punktgenau in den Brennpunkt einer Reflektorkontur (Parabel oder Ellipse) gesetzt werden.

Hinzu kommt eine weitere wesentliche Überlegung, nämlich dass die Höhe der LED deren ohmschen Widerstand beeinflusst. Eine beliebige Verlängerung dieser Höhe ist daher mit deutlichen Nachteilen verbunden. Bevorzugt ist ein Bereich der Höhe von maximal 300 µm, da dann der ohmsche Widerstand relativ gering ist. Auf diese Weise kann dann auch die Verlustleistung begrenzt werden.

Das Podest kann in zwei Ausführungsformen realisiert werden: entweder als ein separates Bauteil oder als ein integraler Bestandteil der Unterlage. Im ersteren Fall kann das Podest optimiert werden was seine Materialbeschaffenheit und Gestalt betrifft, im zweiten Fall entfällt der zusätzliche Herstellschritt und der Justierprozess für das Podest, jedoch ist das Material durch die Unterlage, im allgemeinen das Scheitelbauteil oder der Reflektor, bestimmt. Die Herstellung des separaten Podests erfolgt, indem das Podest aus einem Metallstreifen (aus Kupfer o.ä.) der gewünschten Dicke ausgestanzt wird und dann mittels elektrisch leitendem Kleber -vor Einbringen des Chips -- in den Reflektor eingebracht wird. Diese Technik eignet sich bei einem etwa würfelförmigen Podest. Bei deutlich verlängerter Höhe empfiehlt sich die Verwendung eines Stabes, von dem das Podest abgeschnitten wird.

Die Abstrahlcharakteristik kann dadurch weiter verbessert werden, dass die LED durch eine als Linse wirkende Abdeckung geschützt ist, wobei die Geometrie des Reflektors und der Linse aufeinander abgestimmt ist.

Ein separates Podest kann insbesondere aus gut wärmeleitendem Material bestehen, beispielsweise ein Metall wie Kupfer, so dass eine Überhitzung des Chips auch bei hoher Belastung vermieden wird. Die Herstellung eines integralen Podest lässt sich durch Fräsen der Unterlage (z.B. Reflektorkörper) erreichen.

Eine vorteilhafte Gestalt des Podests ist ein rundes oder rechteckiges Plättchen mit einer Höhe von etwa 100 bis 500 µm ist. Insbesondere kann die Bodenfläche des Podests dem der LED angepasst sein.

Als Verbindungsmaterial zwischen dem Podest und dem Gehäuse bzw. auch zwischen dem Chip und dem Podest kann jeweils ein Kleber, insbesondere der gleiche Kleber verwendet werden. Dieser Kleber kann aus der Grenzfläche austreten, was als Zeichen der ausreichenden Dosierung des Klebers zu werten ist. Dabei sollte jedoch darauf geachtet werden, dass der Kleber insbesondere maximal ein Drittel der Höhe des Chips abdeckt.

Der Reflektor kann eine Kontur besitzen, die der Form einer Parabel, Ellipse oder Kugel entspricht oder sie zumindest annähert. Die ebene Haftfläche des Podests kann an die gekrümmte Oberfläche im Scheitelbereich durch den Kleber angeglichen werden. Die Reflektorkontur kann auch einfach trogförmig sein, oder nur ausschnittweise die Form eines Kegelschnitts besitzen. Die Unterlage für das Podest kann entweder durch den Scheitelbereich des Reflektorkörpers gebildet werden oder ein separates Bauteil sein, das insbesondere eine andere Kontur als der eigentliche Reflektor aufweist, insbesondere kann dieses Scheitelbauteil als ebene Grundfläche gestaltet sein.

Durch das Zusammenwirken von Podest und Chip kann somit die Lage des Chips optimal eingestellt werden.

Podest und Chip sollten möglichst aufeinander abgestimmt werden, bevorzugt indem die Größe der Kontaktfläche des Podests etwa der Größe der Bodenfläche des Chips entspricht, wobei sich die beiden Flächen maximal um höchstens 50 % unterscheiden sollen. Ein rechteckiger Chip kann also auf einem runden Podest mit etwa gleicher Diagonale wie die Kantenlänge des Chips sitzen. Bei gleicher würfelförmiger Gestalt sollte die Kantenlänge des Podests maximal 20 % länger als die des Chips sein. Der Kleber ist vorteilhaft elektrisch leitend und stellt damit die Verbindung des Chips zu einer Stromzuführung her. Bei etwa gleich großer Kontaktfläche quillt immer etwas Kleber heraus und man hat eine einfache Kontrollmöglichkeit für die Dosierung des Klebers. Wählt man aus Sicherheitsgründen deutlich zu viel Kleber, so läuft dieser am Podest hinab und erstarrt an dessen Seitenflächen, also ohne die Reflektorfläche zu reduzieren und die Lichtabstrahlung zu stören.

### Figuren

Im folgenden soll die Erfindung anhand mehrerer Ausführungsbeispiele näher erläutert werden. Es zeigen:
- Figur 1: ein Halbleiterbauelement mit Reflektor;
- Figur 2: die Abstrahlcharakteristik eines derartigen Chips;
- Figur 3: ein weiteres Ausführungsbeispiel eines Halbleiterbauelements mit Reflektor;
- Figur 4: ein weiteres Ausführungsbeispiel eines Halbleiterbauelements mit Reflektor;
- Figur 5: die Abstrahlcharakteristik des in Figur 4 benützten Chips.

### Beschreibung der Zeichnungen

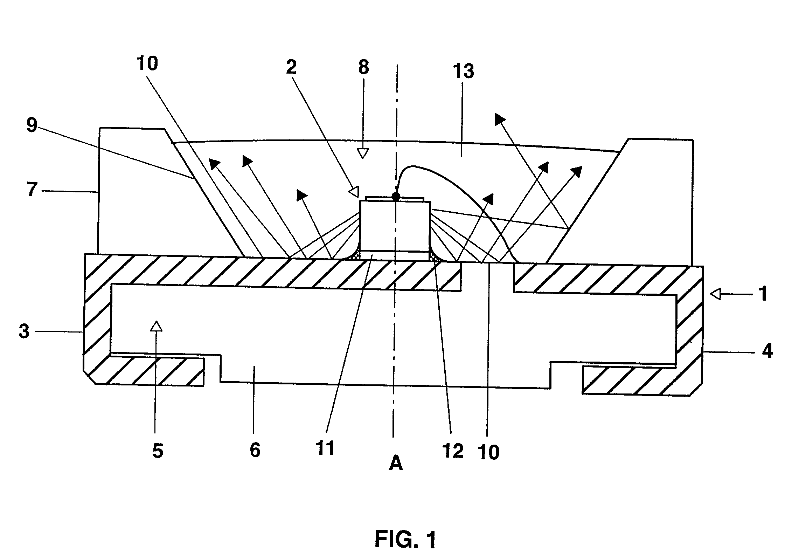

Der Aufbau eines typischen Halbleiterbauelements mit Reflektor ist in Figur 1 dargestellt. Es handelt sich hier um eine Lichtquelle für weißes Licht. Das Halbleiterbauelement 1 besteht aus einer LED 2 (Chip) des Typs InGaN mit einer Peakemissionswellenlänge von 465 nm mit einem ersten und zweiten elektrischen Anschluss 3, 4. Die LED, die eine quadratische Grundfläche besitzt, ist in ein lichtundurchlässiges Gehäuse 5 eingebettet. Es besteht aus einem Basisteil 6 von rechteckiger Gestalt, an dem die Anschlüsse 3, 4 anliegen. Auf ihm sitzt ein quadratischer Reflektorkörper 7 mit einer zentralen Ausnehmung 8. Die Kontur 9 des Reflektors ist kegelstumpfartig zum Basisteil 6 hin verjüngt. Die LED sitzt im Scheitel des Reflektors zentral auf der Reflektorachse A. Als separates Scheitelbauteil 10 wirkt die ebene Oberfläche des Basisteils 6. Es kann jedoch auch eine besonders gut reflektierende separate Bodenplatte als Scheitelbauteil eingesetzt werden. Der Chip 2 hat eine Abmessung von etwa 200 µm x 200 µm und eine Höhe von 250 µm. Er sitzt genau auf einem Podest 11, das dieselben Abmessungen wie der Chip hat bei einer Bauhöhe von 150 µm. Das Podest ist aus einem Kupferblech geschnitten. Ein elektrisch leitender Epoxidkleber 12 verbindet das Scheitelbauteil mit dem Podest und dieses mit dem Chip. Die Ausnehmung 8 ist mit einer Vergussmasse 13 gefüllt, die als Hauptbestandteile ein Epoxidgießharz und Leuchtstoffpigmente enthält. Die primäre Strahlung der LED 2 ist nach vorne zur Reflektoröffnung gerichtet. Ein Bruchteil der Strahlung ist jedoch auch seitlich oder nach hinten gerichtet (Pfeile) und wird schließlich vom Reflektor nach vorne reflektiert. Die primäre Strahlung wird bei ihrem Weg durch die Vergussmasse teilweise von den Leuchtstoffpigmenten in längerwellige Strahlung konvertiert. Das Podest 11 verlängert den Weg der Strahlung in der Vergussmasse und vermindert die Vignettierung.

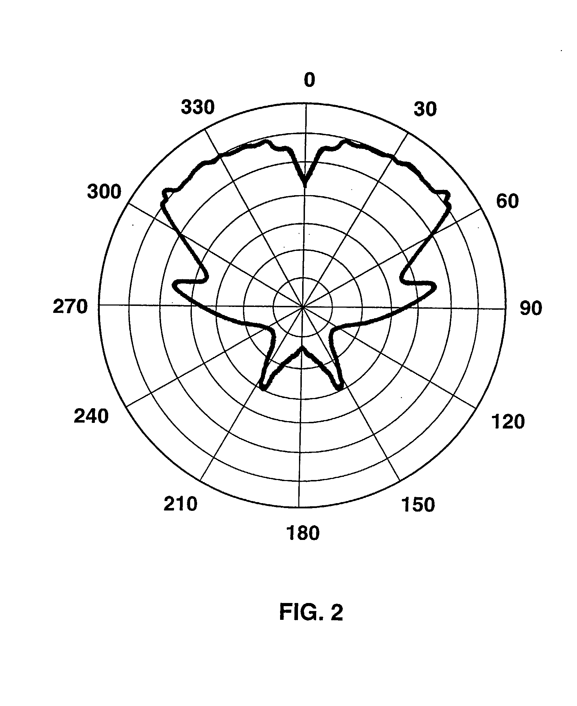

In Figur 2 ist die Abstrahlcharakteristik eines derartigen würfelförmigen Chips (ohne Reflektor) gezeigt. Die Hauptabstrahlung erfolgt nach vorne in einem Bereich zwischen etwa 10 und 45 °. Ein kleiner Teil wird seitlich und nach hinten abgestrahlt. Er wird jetzt durch das Podest besser genützt. Der Lichtstrom wird dadurch um etwa 5 bis 10 % angehoben.

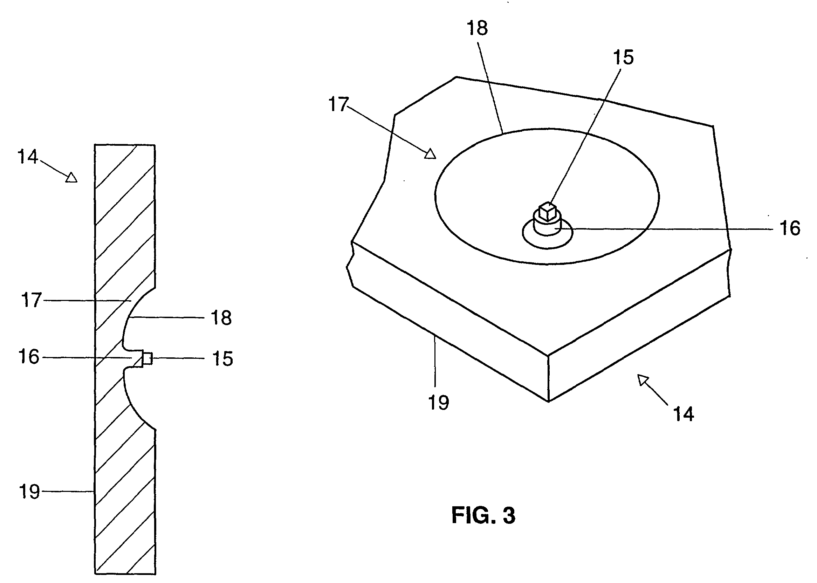

Figur 3 zeigt ein Ausführungsbeispiel eines Halbleiterbauelements 14 mit im Reflektor integriertem Podest. Eine rechteckige LED 15 sitzt im Scheitel des Reflektors auf einem runden (oder kegelstumpfartigen) Podest 16, dessen Kontaktfläche etwas größer ist. Das Podest 16 ist Teil eines Reflektorkörpers 17, dessen durchgehende Kontur 18 parabelförmig ist. Der Reflektorkörper 17 bildet eine Einheit mit dem Basisteil 19.

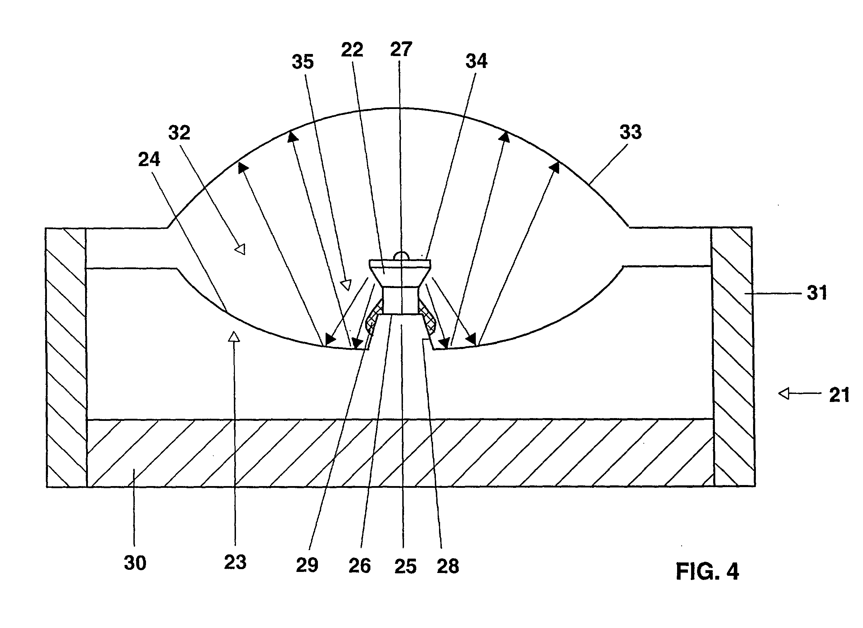

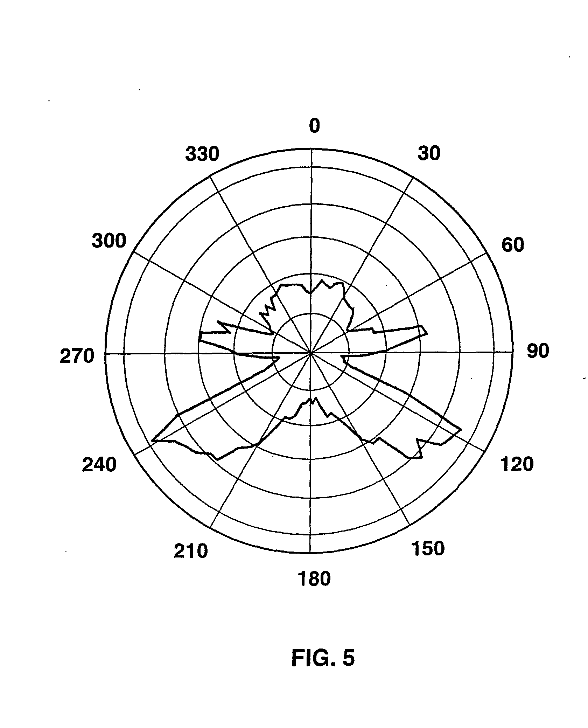

Figur 4 zeigt eine besonders wirksame Ausführungsform der Erfindung. Das Halbleiterbauelement 21 enthält einen Chip 22, der sich nach hinten, zur Basis hin, verjüngt, wobei der Längsschnitt die Gestalt eines Y aufweist. Bei dieser Anordnung, bei der die Seitenwände des Chips auch so schräg stehen können, dass sie gleichmäßig konisch zulaufen, wird erheblich mehr Licht aus dem Chip ausgekoppelt als im Fall rechtwinkliger Seitenwände wie in Figur 1. Dies verdeutlicht die Abstrahlcharakteristik des Chips, die in Figur 5 dargestellt ist. Demnach liegt die Hauptabstrahlrichtung bei einem Winkel zwischen etwa 120 und 140°. Um dieses Licht effektiv im Reflektor 23 zu nutzen, ist der Chip 22 in bezug auf die Reflektorkontur 24, die elliptisch ist, in der Nähe eines Brennpunktes angeordnet. Um dies zu erreichen, sitzt der Chip 22 auf einem Podest 25, das integraler Bestandteil des Reflektors 23 ist. Die Kontaktfläche 26 des Podests ist etwa 20 % größer als die Bodenfläche 27 des Chips. Die Seitenwände 28 des Podests sind leicht angeschrägt, was die Herstellung des Podests durch Fräsen vereinfacht. Der Chip ist mit dem Podest wieder über einen Kleber 29 verbunden.

Der Reflektor 23 sitzt auf einem Basisteil 30 (beide können auch aus einem Teil gebildet sein). Die elektrischen Kontakte sind hier der Einfachheit halber weggelassen. Das Gehäuse wird weiterhin durch Seitenteile 31 vervollständigt, die den Reflektor 23 umgeben. In der Ausnehmung 35 des Reflektors und darüber ist eine Abdeckung 32 aus Gießharz eingebracht, deren Mittelteil als Linse 33 ausgebildet ist. Durch das Zusammenwirken all dieser Komponenten lässt sich eine optimale Abstrahlcharakteristik bei sehr hohem Lichtstrom, der sehr gleichmäßig über die Reflektoröffnung verteilt ist, erzielen.

## Patentansprüche

1. Reflektorbehaftetes Halbleiterbauelement (21), das mindestens eine strahlungsemittierende LED (22), insbesondere auf einem Chip, umfasst, die in einem Gehäuse sitzt, wobei das Gehäuse einen Reflektor (23) für die Umlenkung von Strahlung der LED umfasst, **dadurch gekennzeichnet, dass** die LED (22) im Scheitel des Reflektors an einem Podest (25) befestigt ist.

2. Halbleiterbauelement nach Anspruch 1, **dadurch gekennzeichnet, dass** die LED in einem Chip integiert ist, der jeweils eine rechteckige Bodenfläche und Deckenfläche besitzt, wobei die Deckenfläche zur Öffnung des Reflektors zeigt.

3. Halbleiterbauelement nach Anspruch 1 oder 2, **dadurch gekennzeichnet, dass** ein Bereich um den Scheitel als separate Unterlage (genannt Scheitelbauteil (10)), insbesondere ohne Reflektorkontur, ausgebildet ist, wobei die Unterlage insbesondere durch ein Gehäuseteil gebildet ist.

4. Halbleiterbauelement nach Anspruch 2, **dadurch gekennzeichnet, dass** bei der LED die Fläche der Bodenfläche (27) kleiner als die der Deckenfläche (34) ist.

5. Halbleiterbauelement nach Anspruch 1, **dadurch gekennzeichnet, dass** das Gehäuse ein Basisteil (30) umfasst, auf dem die LED direkt oder indirekt befestigt ist.

6. Halbleiterbauelement nach Anspruch 1, **dadurch gekennzeichnet, dass** das Podest ein separates Bauteil (11) oder integraler Bestandteil (25) des Gehäuses ist.

7. Halbleiterbauelement nach Anspruch 6, **dadurch gekennzeichnet, dass** das Podest (25) aus gut wärmeleitendem Material besteht.

8. Halbleiterbauelement nach Anspruch 1, **dadurch gekennzeichnet, dass** das Podest ein rundes oder rechteckiges Plättchen mit einer Höhe von etwa 100 bis 500 µm ist.

9. Halbleiterbauelement nach Anspruch 1, **dadurch gekennzeichnet, dass** über der LED (22) eine Abdeckung (32) angebracht ist, die als Linse (33) wirkt.

10. Halbleiterbauelement nach Anspruch 3, **dadurch gekennzeichnet, dass** das Podest als separates Bauteil (11) mittels eines Klebers (12) auf der Unterlage befestigt ist, wobei der Kleber insbesondere maximal ein Drittel der Höhe des Chips abdeckt.

11. Halbleiterbauelement nach Anspruch 1, **dadurch gekennzeichnet, dass** der Reflektor eine Kontur (9; 18; 24) besitzt, die die Form eines Kegelschnitts oder einer Parabel, Ellipse oder Kugel zumindest ausschnittweise annähert.

12. Halbleiterbauelement nach Anspruch 1, **dadurch gekennzeichnet, dass** die Bauhöhe des Chips kleiner oder gleich 300 µm ist.

13. Halbleiterbauelement nach Anspruch 2, **dadurch gekennzeichnet, dass** die Kontaktfläche (26) des Podests etwa der Bodenfläche (27) des Chips entspricht, wobei sich die beiden Flächen maximal um höchstens 30 % in ihrer Größe unterscheiden.
